(19)

**Europäisches Patentamt**
**European Patent Office**
**Office européen des brevets**

(11) **EP 4 752 932 A1**

(12) **EUROPEAN PATENT APPLICATION**
published in accordance with Art. 153(4) EPC

(43) Date of publication:
**03.06.2026 Bulletin 2026/23**

(21) Application number: **24845616.2**

(22) Date of filing: **23.07.2024**

(51) International Patent Classification (IPC):
**H01L 21/306** (2006.01)      **C23F 1/18** (2006.01)

(52) Cooperative Patent Classification (CPC):
**C23F 1/18; H10P 50/00**

(86) International application number:
**PCT/JP2024/026313**

(87) International publication number:
**WO 2025/023241 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.07.2023 JP 2023120651**

(71) Applicant: **MITSUBISHI GAS CHEMICAL
COMPANY, INC.**
**Chiyoda-ku**
**Tokyo 100-8324 (JP)**

(72) Inventor: **JIN, Tomoko**
**Tokyo 125-8601 (JP)**

(74) Representative: **Müller-Boré & Partner
Patentanwälte PartG mbB
Friedenheimer Brücke 21
80639 München (DE)**

(54) **ETCHING LIQUID AND PRODUCTION METHOD FOR SEMICONDUCTOR DEVICE USING SAME**

(57)   The present invention relates to: an etching liquid that makes it possible to form a favorable etched surface while controlling how much of the surface of a copper-containing metal layer is etched; and a production method for a semiconductor device that uses the etching liquid. This etching liquid is for etching the surface of a copper-containing metal layer and is characterized by including, relative to the total amount of the etching liquid, (A) more than 0.1 but no more than 0.5 mass% of hydrogen peroxide, (B) 0.01 to 20 mass% of an organic acid that has a lowest acid dissociation constant pKa of at least 2.0, (C) 0.010 to 0.3 mass% of a nitrogen-containing heteromonocyclic compound, and (D) water, the inorganic acid content being less than 0.1 mass%.

EP 4 752 932 A1

**Description**

TECHNICAL FIELD

The present invention relates to an etching liquid for etching the surface of a copper-containing metal layer and a method for producing a semiconductor device using the etching liquid.

BACKGROUND ART

Recently, with size reduction, weight reduction, and sophistication of electronic devices, miniaturization and density increase of metal wiring in semiconductor devices such as semiconductor elements and integrated circuits have been desired. Along with this, it has been desired to improve metal wiring processing technologies, and there is a case where it is required to perform etching while controlling the amount of etching.

For example, in multilayer wiring technologies, as miniaturization and density increase of metal wiring are advanced, short circuits of metal wiring tend to more easily occur due to misalignment at the time of connecting upper and lower metal wiring layers, and this is one of the factors that reduce yields in production lines of semiconductor devices. In the Fully Self Aligned Via (hereinafter also referred to as "FSAV") process, as one of approaches to the above-described problem, it is suggested that a very small amount of recess etching be performed on the surface of a metal embedded in a via or trench of the lower metal wiring layer to expand the distance between the via or trench and the adjacent via or trench, so that short circuits become less likely to occur.

Conventionally, a dry etching process is used after chemical polishing, but the dry etching process may have an impact on the environment. For this reason, it is desirable to use a wet etching process.

Patent Literature 1 describes that an etching liquid, which includes hydrogen peroxide, an inorganic acid having no fluorine atom, an organic acid, an amine compound, an azole, and a hydrogen peroxide stabilizer, and which has a pH value of 2.5 to 5, is suitably used for etching a multilayer thin film having a copper layer and a molybdenum layer contained therein.

Patent Literature 2 describes that, by using a surface treatment agent for copper and copper alloys containing hydrogen peroxide, a mineral acid, an azole, and an aromatic amine compound, the copper surface can be uniformly roughened and adhesion to dry film resists, etc. can be improved.

Further, Patent Literature 3 describes that, by using an aqueous solution containing hydrogen peroxide, phosphoric acid, and an amino group-containing azole, the surface of copper or a copper alloy can be finished into a surface having good adhesion to dry film resists, etc. without roughening the surface.

However, with conventional etching liquids, it is difficult to form a desired etched surface on the surface of a copper-containing metal layer while controlling the amount of etching.

CITATION LIST

PATENT LITERATURES

Patent Literature 1: International Publication WO2011/099624 pamphlet
Patent Literature 2: Japanese Laid-Open Patent Publication No. 2005-133147
Patent Literature 3: Japanese Laid-Open Patent Publication No. 2009-299096

SUMMARY OF INVENTION

TECHNICAL PROBLEM

It has been desired to provide an etching liquid that makes it possible to form a favorable etched surface of a copper-containing metal layer while controlling the amount of etching of the surface, and a method for producing a semiconductor device using the etching liquid.

SOLUTION TO PROBLEM

The present invention relates to an etching liquid and a method for producing a semiconductor device as described below.

[1] An etching liquid for etching the surface of a copper-containing metal layer, the etching liquid comprising, based on the total amount of the etching liquid,

(A) more than 0.1 but not more than 0.5% by mass of hydrogen peroxide,
(B) 0.01 to 20% by mass of an organic acid that has a lowest acid dissociation constant pKa of at least 2.0,
(C) 0.010 to 0.3% by mass of a nitrogen-containing heteromonocyclic compound, and
(D) water,

the inorganic acid content being less than 0.1% by mass.

[2] The etching liquid according to item [1], wherein the component (B) is a carboxylic acid having less than three carboxyl groups.

[3] The etching liquid according to item [1] or [2], wherein the component (B) is a carboxylic acid having less than two hydroxyl groups and at least one carbon atom that is not included in a carboxyl group.

[4] The etching liquid according to any one of items [1] to [3], wherein the component (B) is at least one selected from the group consisting of malic acid, succinic acid, lactic acid, and acetic acid.

[5] The etching liquid according to any one of items [1] to [4], wherein the component (C) is at least one selected from the group consisting of triazoles, tetrazoles, thiazoles, pyrazoles, imidazoles, and nucleic acid bases.

[6] The etching liquid according to item [5], wherein the component (C) is at least one selected from tetrazoles having a substituent at 5-position.

[7] The etching liquid according to item [6], wherein the component (C) is 5-amino-1H-tetrazole.

[8] The etching liquid according to any one of items [1] to [7], which has a pH value of lower than 4.0.

[9] The etching liquid according to any one of items [1] to [8], wherein the etching rate of copper is 1.5 to 40 nm/min.

[10] The etching liquid according to any one of items [1] to [9], wherein the etching rate of copper when using the etching liquid after dissolving 50 mass ppm of copper is in the range of: the etching rate of copper when using the etching liquid before dissolving copper $\pm$ 2 nm/min.

[11] The etching liquid according to any one of items [1] to [10], which is for performing recess etching on the surface of a copper-containing metal layer that is embedded in a via or trench formed in a semiconductor substrate.

[12] A method for producing a semiconductor device, the method comprising a step of contacting the etching liquid according to any one of items [1] to [11] with the surface of a copper-containing metal layer to perform etching.

[13] The method for producing a semiconductor device according to item [12], wherein the step comprises contacting the etching liquid with the surface of a copper-containing metal layer that is embedded in a via or trench formed in a semiconductor substrate to perform recess etching.

[14] The method for producing a semiconductor device according to item [12] or [13], wherein the normalized spectral entropy $H_n$, which is calculated from a 512-pixel x 512-pixel image data that is obtained by observing an arbitrary 500 nm x 500 nm area of the etched surface of the copper-containing metal layer obtained in the step using a scanning electron microscope, is 0.83 or more.

## ADVANTAGEOUS EFFECTS OF INVENTION

The etching liquid of the present invention is suitably used as an etching liquid for the surface of a copper-containing metal layer. According to a preferred aspect of the present invention, a favorable etched surface can be formed while controlling the amount of etching. Further, according to a preferred aspect of the present invention, even after copper of a copper-containing metal layer to be etched is eluted due to use of the etching liquid of the present invention, the change of the etching rate can be suppressed, and the performance of the etching liquid can be maintained.

## BRIEF DESCRIPTION OF DRAWINGS

[FIG.1] FIG. 1 illustrates a process of recess etching using the etching liquid of the present invention.
[FIG. 2] FIG. 2 shows SEM images of the surfaces of the evaluation samples: (a) after etching in Example 1, (b) after etching in Comparative Example 2, and (c) untreated (each observed at a magnification of 100,000 times).

## DESCRIPTION OF EMBODIMENTS

1. Etching Liquid

The etching liquid of the present invention is an etching liquid for etching the surface of a copper-containing metal layer and is characterized in that the etching liquid includes, based on the total amount of the etching liquid,

(A) more than 0.1 but not more than 0.5% by mass of hydrogen peroxide,
(B) 0.01 to 20% by mass of an organic acid that has a lowest acid dissociation constant pKa of at least 2.0,
(C) 0.010 to 0.3% by mass of a nitrogen-containing heteromonocyclic compound, and
(D) water,

and that the inorganic acid content is less than 0.1% by mass.

Hereinafter, the respective components will be described.

(A) Hydrogen Peroxide

In the present invention, hydrogen peroxide (hereinafter also referred to as the component (A)) is a component that functions as an oxidizing agent for copper.

The component (A) is not particularly limited, and materials of various grades such as industrial and electronics industrial grades can be used. In general, use as an aqueous hydrogen peroxide solution is preferred from the viewpoint of availability and ease of handling.

The content of the component (A) is more than 0.1 but not more than 0.5% by mass, preferably more than 0.10 but not more than 0.50% by mass, more preferably 0.12 to 0.50% by mass, even more preferably 0.15 to 0.50% by mass, and particularly preferably 0.20 to 0.50% by mass based on the total amount of the etching liquid. In the present invention, by adjusting the content of the component (A) within the above-described range, the etching amount can be controlled, and a smooth surface can be formed without roughening the surface. Further, even after copper is dissolved into the etching liquid from the copper-containing metal layer to be etched by etching, the change of the etching rate can be suppressed, and the performance of the etching liquid can be maintained.

Note that when numerical ranges are shown in this specification, upper limits and lower limits thereof can be suitably combined, and it is considered that numerical ranges obtained therefrom are also disclosed.

(B) Organic Acid that has Lowest Acid Dissociation Constant pKa of at least 2.0

In the present invention, the organic acid that has a lowest acid dissociation constant pKa of at least 2.0 (hereinafter also referred to as the component (B)) has etching effects on a copper-containing metal layer.

The component (B) is not particularly limited as long as it has a lowest acid dissociation constant pKa of at least 2.0. Specifically, when there are a plurality of acidic hydroxyl groups in one molecule, dissociation occurs in stages, resulting in a plurality of pKas, and in this case, an organic acid having a lowest acid dissociation constant pKa of at least 2.0, which is the lowest among said plurality of pKas, is included in the component (B). The lowest acid dissociation constant pKa of the component (B) is preferably 2.5 or more and 7 or less, more preferably 3.0 or more and 6 or less, even more preferably 3.1 or more and 5.5 or less, and particularly preferably 3.2 or more and 5 or less.

Examples of the component (B) include a carboxylic acid such as an aliphatic carboxylic acid and an aromatic carboxylic acid, and an amino acid. Among them, a carboxylic acid having less than three carboxyl groups is preferred, and a carboxylic acid having one or two carboxyl groups is more preferred. As the carboxylic acid, an aliphatic carboxylic acid and an aromatic carboxylic acid are preferred, and it is more preferably at least one selected from the group consisting of an aliphatic carboxylic acid having 1 to 12 carbon atoms and an aromatic carboxylic acid having 6 to 16 carbon atoms, and particularly preferably an aliphatic carboxylic acid having 1 to 6 carbon atoms.

Further, as the component (B), a carboxylic acid having less than two hydroxyl groups and at least one carbon atom that is not included in the carboxyl groups is more preferred, and a carboxylic acid having zero or one hydroxyl group and one or two carbon atoms that are not included in the carboxyl groups is even more preferred.

Examples of the aliphatic carboxylic acid include formic acid, acetic acid, propionic acid, lactic acid, glycolic acid, diglycolic acid, butyric acid, hydroxybutyric acid, succinic acid, malic acid, valeric acid, glutaric acid, itaconic acid, adipic acid, caproic acid, propanetricarboxylic acid, enanthic acid, caprylic acid, nonanoic acid, capric acid, lauric acid, myristic acid, palmitic acid, and sorbic acid. These substances may be used solely, or two or more of them may be used in combination. Among them, as the aliphatic carboxylic acid, acetic acid, lactic acid, succinic acid, malic acid, propionic acid, glycolic acid, and a combination thereof are preferred.

Examples of the aromatic carboxylic acid include benzoic acid, terephthalic acid, mandelic acid, 2-methylbenzoic acid, 3-methylbenzoic acid, 4-methylbenzoic acid, 2-ethylbenzoic acid, 3-ethylbenzoic acid, 4-ethylbenzoic acid, 3-hydroxybenzoic acid, 4-hydroxybenzoic acid, 3-chlorobenzoic acid, 4-chlorobenzoic acid, 2-fluorobenzoic acid, 3-fluorobenzoic acid, 4-fluorobenzoic acid, 2-cyanobenzoic acid, 3-cyanobenzoic acid, 4-cyanobenzoic acid, 3-nitrobenzoic acid, 4-nitrobenzoic acid, 2,3-dimethylbenzoic acid, 3,4-dimethylbenzoic acid, 3,5-dimethylbenzoic acid, 2,5-dimethylbenzoic acid, 2,6-dimethylbenzoic acid, 2-hydroxy-4-methylbenzoic acid, 2-hydroxy-5-methylbenzoic acid, 2-hydroxy-6-methylbenzoic acid, 3-hydroxy-2-methylbenzoic acid, 3-hydroxy-4-methylbenzoic acid, 3-hydroxy-5-methylbenzoic acid, 5-hydroxy-2-methylbenzoic acid, 4-hydroxy-2-methylbenzoic acid, 4-hydroxy-3-methylbenzoic acid, 2-methoxybenzoic acid, 3-methoxybenzoic acid, 4-methoxybenzoic acid, 3,4-dihydroxybenzoic acid, 3,5-dihydroxybenzoic acid, 2,5-dihydroxybenzoic acid, 2,4,5-trimethylbenzoic acid, 2,4,6-trimethylbenzoic acid, 1-naphthalenecarboxylic acid, 2-naphthalenecarboxylic acid, 1-hydroxy-2-naphthalenecarboxylic acid, 6-hydroxy-1-naphthalenecarboxylic acid, 6-hydroxy-2-naphthalenecarboxylic acid, 2-hydroxy-1-naphthalenecarboxylic acid, 1-anthracenecarboxylic acid, 2-anthracenecarboxylic acid, 9-anthracenecarboxylic acid, gallic acid, and cinnamic acid.

These substances may be used solely, or two or more of them may be used in combination.

As the component (B), only one of an aliphatic carboxylic acid and an aromatic carboxylic acid may be used, or an aliphatic carboxylic acid and an aromatic carboxylic acid may be used in combination, but more preferably, one or more types of aliphatic carboxylic acids are used.

The content of the component (B) is, based on the mass of the etching liquid, 0.01 to 20% by mass, preferably 0.1 to 19.5% by mass, more preferably 0.5 to 19.0% by mass, even more preferably 1.0 to 18.5% by mass, and particularly preferably 3.0 to 18.0% by mass, and for example, the content may be 3 to 17.78% by mass or 3.0 to 17.78% by mass, and still more preferably 3.0 to 15.0% by mass. In the case of using two or more types of compounds as the component (B), it is sufficient when the total amount thereof is within the above-described range.

(C) Nitrogen-Containing Heteromonocyclic Compound

In the present invention, the nitrogen-containing heteromonocyclic compound (hereinafter also referred to as the component (C)) can act as a corrosion inhibitor for copper. The component (C) is not particularly limited as long as it is a compound that contains a nitrogen atom as a heteroatom constituting a ring. Examples thereof include triazoles, tetrazoles, thiazoles, pyrazoles, imidazoles, and nucleic acid bases.

Examples of triazoles include 1,2,3-triazole, 1,2,4-triazole, 3,5-dimethyl-1,2,4-triazole, 3-amino-1,2,4-triazole, 4-amino-1,2,4-triazole, 3-mercapto-4-methyl-4H-1,2,4-triazole, 1H-benzotriazole, 1H-benzotriazole-1-methanol, 4-methyl-1H-benzotriazole, 2-(2-hydroxy-5-methylphenyl)benzotriazole, 5-methyl-1H-benzotriazole, 3-chloro-1H-benzotriazole, 5-chloro-1H-benzotriazole, methyl 1,2,4-triazole-3-carboxylate, 2-(5-chloro-2-benzotriazolyl)-6-tert-butyl-p-cresol, and 3-amino-1H-triazole.

Examples of tetrazoles include 1H-tetrazole, 5-methyl-1H-tetrazole, 5-phenyl-1H-tetrazole, 5-mercapto-1-methyl-1H-tetrazole, 5-mercapto-1-phenyl-1H-tetrazole, 5-benzyl-1H-tetrazole, and 5-amino-1H-tetrazole.

Examples of thiazoles include 1,3-thiazole and 4-methylthiazole.

Examples of pyrazoles include pyrazole and 3,5-dimethylpyrazole.

Examples of imidazoles include imidazole, 2-methylimidazole, 1-propylimidazole, 1-isopropylimidazole, 2-undecylimidazole, 2-phenylimidazole, benzimidazole, 2-methylbenzimidazole, and 2-hydroxybenzimidazole.

Examples of nucleic acid bases include pyrimidine, uracil, thymine, and cytosine. These substances may be used solely, or two or more of them may be used in combination.

Among them, as the component (C), tetrazoles are preferred, and the component (C) is more preferably at least one selected from tetrazoles having a substituent at 5-position.

Examples of the substituent in this case include a hydrocarbon group having 1 to 10 carbon atoms ($C_1$-$C_{10}$) (for example, a $C_1$-$C_{10}$ alkyl group, a $C_1$-$C_{10}$ alkenyl group, a $C_1$-$C_{10}$ alkynyl group, a $C_6$-$C_{10}$ aryl group, a $C_7$-$C_{10}$ alkylaryl group, and a $C_7$-$C_{10}$ arylalkyl group), an alkoxy group having 1 to 10 carbon atoms ($C_1$-$C_{10}$), an alkylaryloxy group having 7 to 10 carbon atoms ($C_7$-$C_{10}$), an alkoxycarbonyl group having 2 to 10 carbon atoms ($C_2$-$C_{10}$), an amino group which may have a substituent (for example, an amino group, a dimethylamino group, a methylamino group, a methylphenylamino group, and a phenylamino group), a hydroxyl group, and a mercapto group.

Examples of the alkyl group include a methyl group, an ethyl group, a propyl group, an isopropyl group, a n-butyl group, a sec-butyl group, a tert-butyl group, a pentyl group, a hexyl group, an octyl group, a nonyl group, and a decyl group.

Examples of the alkenyl group include a vinyl group, an allyl group, a propenyl group, an isopropenyl group, a 2-methyl-1-propenyl group, a 2-methylallyl group, and a 2-butenyl group.

Examples of the alkynyl group include an ethynyl group, a propynyl group, and a butynyl group.

Examples of the aryl group include a phenyl group, a 1-naphthyl group, a 2-naphthyl group, an indenyl group, a biphenyl group, an anthryl group, and a phenanthryl group.

Examples of the alkylaryl group include a tolyl group, a xylyl group, a cumenyl group, and a mesityl group.

Examples of the arylalkyl group include a benzyl group, a phenethyl group, a 1-naphthylmethyl group, a 2-naphthylmethyl group, a 1-phenylethyl group, a phenylpropyl group, a phenylbutyl group, a phenylpentyl group, a phenylhexyl group, a methylbenzyl group, a dimethylbenzyl group, a trimethylbenzyl group, an ethylbenzyl group, a methylphenethyl group, a dimethylphenethyl group, and a diethylbenzyl group.

Among them, 5-amino-1H-tetrazole is preferred as the component (C).

The content of the component (C) is 0.010 to 0.3% by mass, preferably 0.010 to 0.2% by mass, and more preferably 0.010 to 0.15% by mass based on the mass of the etching liquid. In the case of using two or more types of compounds as the component (C), it is sufficient when the total amount thereof is within the above-described range.

(D) Water

The etching liquid of the present invention includes water (hereinafter also referred to as the component (D)) as a diluent. The water is preferably water from which metal ions, organic impurities, particles, etc. have been removed by distillation, ion exchange treatment, filtering treatment, adsorption treatment or the like, and it is particularly preferably pure water or ultrapure water.

The content of the component (D) is the remainder in the etching liquid, and it is preferably 70% by mass or more, more preferably 75 to 99.9% by mass, and even more preferably 80 to 99.9% by mass based on the mass of the etching liquid.

(E) Other Components

In addition to the aforementioned component (A), component (B), component (C) and component (D), the etching liquid of the present invention may contain additives such as an alcohol, a phosphonic acid-based compound, a glycol-based compound, a surfactant, an oxidizing agent, a reducing agent, a chelating agent, and an alkali, which are generally used for etching copper-containing metal layers, within ranges in which the effects of the present invention are not inhibited.

However, when an inorganic acid (including, for example, sulfuric acid, nitric acid, hydrochloric acid, phosphoric acid, etc.) is contained, the surface after etching becomes rough and it is difficult to obtain a smooth surface. For this reason, preferably, the etching liquid of the present invention substantially does not contain any inorganic acid, and the content of the inorganic acid is less than 0.1% by mass based on the mass of the etching liquid. The content of the inorganic acid is preferably less than 0.05% by mass, more preferably less than 0.03% by mass, and even more preferably less than 0.01% by mass based on the mass of the etching liquid.

According to a preferred aspect of the present invention, the total content of the aforementioned component (A), component (B), component (C) and component (D) is preferably 95% by mass or more, more preferably 96 to 100% by mass, even more preferably 97 to 100% by mass, still more preferably 98 to 100% by mass, and particularly preferably 99 to 100% by mass based on the mass of the etching liquid.

The pH of the etching liquid of the present invention is not particularly limited, but it is preferably lower than 4, more preferably 1.0 to 3.8, even more preferably 1.2 to 3.6, and particularly preferably 1.3 to 3.6.

In the etching liquid of the present invention, for adjusting the pH range, a pH adjuster may be added according to need. As the pH adjuster, for example, potassium hydroxide, lithium hydroxide, cesium hydroxide, triethylamine, ammonia, tetramethylammonium hydroxide, ethanolamine, 1-amino-2-propanol, etc. can be used. These pH adjusters may be used solely, or two or more of them may be used in combination.

The etching liquid of the present invention can be prepared by homogeneously stirring the aforementioned components (A) to (D) and, according to need, the aforementioned other components (E). Note that a part or all of the water as the component (D) may be added later. Further, a liquid containing the components (A) to (C), a part of the component (D), and according to need, the other components (E) may be prepared in advance and stored, and then diluted with the remainder of the component (D) before use.

The etching rate of the etching liquid of the present invention for copper, at a process temperature of 25°C, is preferably 1.5 to 40 nm per minute (nm/min), more preferably 1.8 to 40.0 nm/min, and even more preferably 2.0 to 38.0 nm/min. When the etching rate is too high, it is difficult to control the amount of etching, and when the amount of etching is controlled, etching cannot be performed uniformly, and it is difficult to obtain a smooth etched surface. Conversely, when the etching rate is too low, the etching process takes a long time, and it is undesirable in terms of work efficiency.

The etching liquid of the present invention can uniformly etch the surface of a copper-containing metal layer while controlling the amount of copper etched, and can form a good etched surface. Since the amount of copper etched can be controlled by using the etching liquid of the present invention, it can be suitably used when etching a fine region, and can cope with miniaturization and density increase of metal wiring.

By contacting the etching liquid of the present invention with the surface of a copper-containing metal layer, the surface of the copper-containing metal layer can be etched.

The temperature of the etching liquid of the present invention at the time of use is not particularly limited, but it is, for example, 0 to 70°C, preferably 10 to 50°C, more preferably 20 to 45°C, and even more preferably 25 to 40°C. When the temperature of the etching liquid is 10°C or higher, a good etching rate is obtained, and therefore excellent production efficiency can be obtained. Meanwhile, when the temperature of the etching liquid is 50°C or lower, the change in the liquid composition can be suppressed, and the etching conditions can be kept constant. By increasing the temperature of the etching liquid, the etching rate is increased, but the optimum process temperature may be suitably determined while giving consideration to, for example, suppression of the change in the composition of the etching liquid (decomposition of hydrogen peroxide).

The etching process time of the etching liquid of the present invention is not particularly limited, but it is preferably from 15 seconds to 10 minutes, more preferably from 30 seconds to 7.5 minutes, and even more preferably from 30 seconds to 5 minutes. The process time may be suitably selected depending on various conditions such as the surface state of the copper-containing metal layer to be etched, the concentration of the etching liquid, the temperature, and the processing method.

The method for contacting the etching liquid with an object to be etched is not particularly limited. For example, it is possible to employ a method of contacting the etching liquid with the object to be etched by means of dropping (single wafer spin process), spray or the like, or a wet etching method such as a method of immersing the object to be etched in the etching liquid. In the present invention, any of such methods may be employed.

The object to be etched by the etching liquid of the present invention is a copper-containing metal layer. As the copper-containing metal layer, a copper layer or a copper alloy layer is preferred. The copper content in the copper alloy layer is preferably 50% by mass or more, more preferably 70% by mass or more, even more preferably 90% by mass or more, particularly preferably 95% by mass or more, and may be 99% by mass or more. The copper-containing metal layer may be, for example, any of an electrolytic copper foil, an electrolytic copper plating film, and an electroless copper plating film, or a combination thereof.

The thickness (etching depth) of the copper-containing metal layer to be etched by using the etching liquid of the present invention is not particularly limited, but it is preferably 2.5 to 50 nm, more preferably 5 to 40 nm, even more preferably 5 to 35 nm, and particularly preferably 5 to 30 nm.

The width (wiring width) of the copper-containing metal layer to be etched by using the etching liquid of the present invention is not particularly limited, but since the amount of etching can be controlled, it is possible to cope with narrower pitches for metal wiring.

When the etching liquid is used a plurality of times or for a long period of time, the change of the etching rate may occur due to elution of copper from the copper-containing metal layer. According to a preferred aspect of the present invention, this phenomenon can be suppressed by adjusting the concentrations of the components (A), (B), and (C) to the following.

(A) Hydrogen peroxide: more than 0.1 but not more than 0.5% by mass
(B) Organic acid that has a lowest acid dissociation constant pKa of at least 2.0: 0.01 to 20% by mass
(C) Nitrogen-containing heteromonocyclic compound: 0.010 to 0.3% by mass

According to a preferred aspect of the present invention, by adjusting the composition of the etching liquid of the present invention within the above-described ranges, the change of the etching rate is suppressed. Even when 50 mass ppm of copper is dissolved, the difference in the etching rate between before dissolution and after dissolution is within $\pm 2$ nm/min. The difference is more preferably within $\pm 1.8$ nm/min, even more preferably within $\pm 1.5$ nm/min, and particularly preferably within $\pm 1.0$ nm/min.

The etching liquid of the present invention can be suitably used when processing metal wiring in a step of a method for producing a semiconductor device. According to a preferred aspect of the present invention, the etching liquid can be suitably used for processing fine metal wiring since a favorable etched surface can be formed while controlling the amount of etching.

The aforementioned favorable etched surface is an etched surface with few irregularities in a microscopic area. Evaluation of the irregularities of an etched surface can be easily made by observing a scanning electron microscope image. The method for calculating the normalized spectral entropy, which indicates the degree of irregularities, from this image is as described below.

From an image data obtained at the time of observation, a 512-pixel x 512-pixel image is extracted from a 500 nm x 500 nm area, and the brightness data Id (l, m) of each pixel is standardized as follows to obtain Is (l, m). Note that is a pair of two natural numbers indicating a pixel position.

[Math. 1]

$$I_s(l,m) = \frac{I_d(l,m) - \mu}{\sigma}$$

$\mu$ and $\sigma$ are the average value and the standard deviation of the brightness data of a 512-pixel x 512-pixel, respectively.

Is (l, m) is subjected to a fast Fourier transform to calculate S ($k_l$, $k_m$). S ($k_l$, $k_m$) is a complex matrix with 512 rows and 512 columns. Note that $(k_l, k_m)$ is a two-dimensional vector whose components are natural numbers proportional to spatial frequency.

A power spectrum p $(k_l, k_m)$ is calculated from S $(k_l, k_m)$ using the following formula.

[Math. 2]

$$\mathrm{p}\,(k_l, k_m) = \frac{|S(k_l, k_m)|^2}{\sum_{k_l, k_m} |S(k_l, k_m)|^2}$$

According to the formula above, the sum of power spectra is 1. Accordingly, the power spectrum p $(k_l, k_m)$ is an amount that indicates the ratio of contribution of spatial frequency $(k_l, k_m)$ to the light and dark patterns of the image.

The spectral entropy H of the image is calculated using the following formula.

[Math. 3]

$$H = -\sum_{k_l, k_m} p(k_l, k_m) \log_2 p(k_l, k_m)$$

The spectral entropy is maximum in the state where the light and dark parts in the image are arranged in a completely random manner. The value becomes smaller as a regular pattern is formed.

The normalized entropy is obtained by dividing the actual spectral entropy by the maximum value of the spectral entropy $H_{MAX}$, which will be described later, and is employed as an index of the light and dark parts of the scanning electron microscope image, i.e., the irregularity pattern of the etched surface.

In the state where the spectral entropy is maximum, there is no contribution of spatial frequency $(k_l, k_m)$, and the sum of power spectra p $(k_l, k_m)$ is 1. Therefore, the power spectrum p $(k_l, k_m)$ in this state is as follows (N=512).

[Math. 4]

$$\mathrm{p}\,(k_l, k_m) = \frac{1}{N^2}$$

Accordingly, the maximum value of the spectral entropy $H_{MAX}$ is as follows.

[Math. 5]

$$H_{MAX} = -\sum_{k_l, k_m} \frac{1}{N^2} \log_2 \frac{1}{N^2} = -N^2 \cdot \frac{1}{N^2} \log_2 \frac{1}{N^2} = -\log_2 \frac{1}{N^2} = \log_2 N^2$$

Accordingly, the normalized spectral entropy $H_n$ is expressed as follows.

[Math. 6]

$$H_n = \frac{H}{H_{MAX}} = \frac{-\sum_{k_l, k_m} p(k_l, k_m) \log_2 p(k_l, k_m)}{\log_2 N^2}$$

In the case of a completely random image, the normalized spectral entropy $H_n$ is 1.

For semiconductor devices, a favorable etched surface, i.e., an etched surface with few irregularities, is an etched surface, wherein the normalized spectral entropy $H_n$ of a 512-pixel x 512-pixel image of a 500 nm x 500 nm area obtained using a scanning electron microscope is 0.83 or more.

Preferred is an etched surface, wherein the normalized spectral entropy $H_n$ is 0.85 or more. Such an etched surface can be easily realized by using the etching liquid of the present invention.

The upper limit of the normalized spectral entropy $H_n$ is not particularly limited as long as it is 1 or less, but when it is 0.97 or more, there is a high possibility that etching has not been performed at all or that observation with a scanning electron microscope has not been normally performed.

According to one embodiment of the present invention, the etching liquid of the present invention can be suitably used as a recess etching liquid for performing recess etching on the surface of a copper-containing metal layer that is embedded in a via or trench formed in a semiconductor substrate.

2. Method for Producing Semiconductor Device

Next, the method for producing a semiconductor device of the present invention will be described.

The method for producing a semiconductor device of the present invention includes a step of contacting the etching liquid of the present invention with the surface of a copper-containing metal layer to perform etching.

The method for contacting the etching liquid with the surface of a copper-containing metal layer, the temperature of the etching liquid during contact, and the contact time are as described in "1. Etching Liquid" above.

After etching is performed by contacting the etching liquid with the copper-containing metal layer, according to need, washing may be suitably performed using water, isopropyl alcohol, an aqueous solution of ammonia, an aqueous solution of tetramethylammonium hydroxide, or the like. Further, an anti-rust treatment may be performed using an aqueous solution containing a rust inhibitor.

In one embodiment of the present invention, the aforementioned step may be a recess etching step in which the etching liquid is brought into contact with the surface of a copper-containing metal layer that is embedded in a via or trench formed in a semiconductor substrate to perform recess etching. In this case, it is possible to produce a semiconductor substrate in which the surface of a copper-containing metal layer that is embedded in a via or trench formed in the semiconductor substrate is recess-etched. By stacking copper-containing metal layers on this semiconductor substrate, a wiring circuit can be constructed.

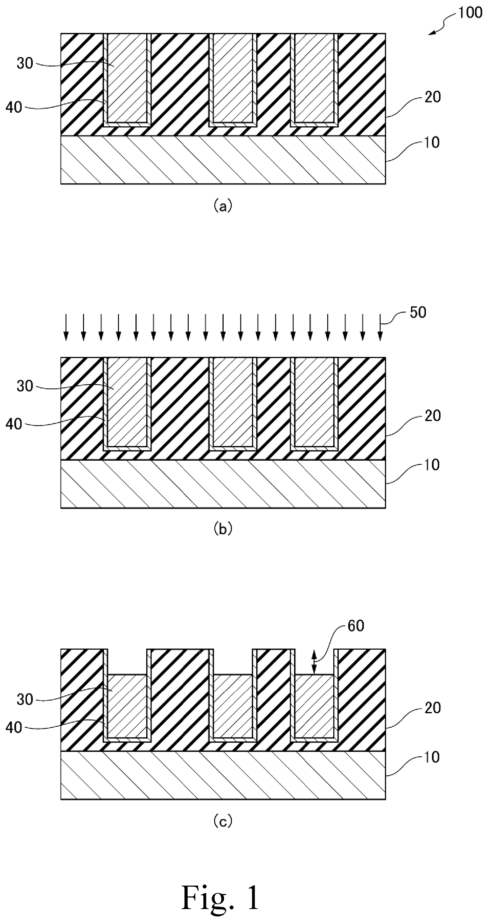

Figure 1 illustrates a process of recess etching using the etching liquid of the present invention. In Figure 1, only the structures required for illustrating the process of recess etching are schematically shown.

Firstly, as shown in Figure 1(a), a semiconductor substrate 100 having a wiring structure, in which a via or trench is formed in an interlayer insulating film 20 provided on a substrate 10 and a copper-containing metal layer 30 is embedded in the via or trench, is prepared.

A barrier metal layer 40 such as a titanium layer and a titanium nitride layer may be formed on the inner wall of the via or trench.

The semiconductor substrate 100 can be produced by a method commonly used in the industry. For example, it can be produced as follows.

Firstly, the interlayer insulating film 20 is formed on the substrate 10.

Next, a via or trench is formed in the interlayer insulating film 20 by means of dry etching or the like. In addition, according to need, the barrier metal layer 40 is formed on the inner wall of the via or trench.

Next, the copper-containing metal layer 30 is formed in a manner such that it fills the via or trench formed in the interlayer insulating film 20.

Lastly, CMP (chemical mechanical polishing) is performed according to need, thereby obtaining the semiconductor substrate 100 whose upper part is smooth.

Next, as shown in Figure 1(b), an etching liquid 50 of the present invention is brought into contact with the surface of the copper-containing metal layer 30 exposed on the upper part of the semiconductor substrate 100.

The method for contacting the etching liquid 50 with the surface of the copper-containing metal layer 30 is not particularly limited. For example, it is possible to employ a method of contacting the etching liquid with the surface of the copper-containing metal layer 30 by means of dropping (single wafer spin process), spray or the like, or a method of immersing the surface of the copper-containing metal layer 30 in the etching liquid.

The temperature of the etching liquid at the time of contacting the etching liquid 50 with the copper-containing metal layer 30 is not particularly limited, but it is, for example, 0 to 70°C, preferably 25 to 65°C, more preferably 25 to 60°C, and even more preferably 25 to 50°C. When the temperature of the etching liquid is 25°C or higher, recess etching can be performed in a shorter time. Meanwhile, when the temperature is 50°C or lower, the change in the liquid composition can be suppressed, and the processing conditions can be kept constant.

The time for contacting the etching liquid 50 with the copper-containing metal layer 30 (processing time) is not particularly limited, but usually, it is preferably from 15 seconds to 10 minutes, more preferably from 30 seconds to 7.5 minutes, and even more preferably from 30 seconds to 5 minutes. The optimum processing time may be suitably selected depending on the method for contacting the etching liquid with the copper-containing metal layer, the temperature of the etching liquid, etc.

When recess etching is performed on the copper-containing metal layer using the etching liquid of the present invention, the etching rate of the copper-containing metal layer is preferably 1.5 to 40 nm/min, more preferably 1.8 to 40.0 nm/min, and even more preferably 2.0 to 38.0 nm/min.

By contacting the etching liquid 50 with the surface of the copper-containing metal layer 30 in the above-described manner, recess etching can be performed on the surface of the copper-containing metal layer 30, as shown in Figure 1(c). The barrier metal layer 40 at the recess-etched portion may be removed by performing another etching in a step after recess etching, or may be left as it is and used in the next step without being subjected to an etching step.

The preferred amount of recess etching performed on the copper-containing metal layer (i.e., the depth of the recess formed by performing recess etching on the copper-containing metal layer) is not particularly limited, but it is preferably 2.5 to 40 nm, more preferably 5 to 40 nm, and even more preferably 7.5 to 40 nm.

In one embodiment of the present invention, the method for producing a semiconductor device of the present invention includes:

a recess etching step in which the above-described etching liquid is brought into contact with the surface of a copper-containing metal layer that is embedded in a via or trench formed in a semiconductor substrate to perform recess etching on the surface of the copper-containing metal layer; and

a step of obtaining the semiconductor device in which metal wiring layers are stacked on the surface of the copper-containing metal layer in the surface-treated semiconductor substrate obtained in the aforementioned step to construct a wiring circuit.

According to a preferred aspect of the present invention, since a smooth recess-etched surface can be formed on the copper-containing metal wiring in the recess etching step, when a wiring circuit is constructed by stacking metal wiring layers, short circuits of the metal wiring do not easily occur, and a semiconductor device having excellent electrical properties can be obtained.

The metal wiring layer that can be stacked on the surface of the copper-containing metal layer is not particularly limited as long as it can be electrically connected to the copper-containing metal layer (for example, those containing copper or cobalt). The metal wiring layer that can be stacked on the surface of the copper-containing metal layer may be one layer or two or more layers.

EXAMPLES

Hereinafter, the present invention will be more specifically described by way of working examples and comparative examples, but the present invention is not limited thereto.

Examples 1 to 4

(1) Preparation of Etching Liquid and Preparation of Copper-Dissolved Etching Liquid

Components were mixed at the composition ratio (based on mass) shown in Table 1, and stirred to make a homogeneous state to prepare an etching liquid. Further, after mixing the components at the composition ratio shown in Table 1, copper (Cu) powder manufactured by Sigma-Aldrich was added in an amount of 50 mass ppm relative to the total mass of the etching liquid, and the mixture was stirred to make a homogeneous state to prepare a copper-dissolved etching liquid.

(2) Etching of Copper-Containing Metal Layer

As an evaluation sample for the etching liquid, a PVD-Cu solid film manufactured by Philtech Inc., which has a copper layer (thickness: 0.3 $\mu$m) on the substrate surface, was used.

Next, the surface of the evaluation sample was immersed in the etching liquid (25°C) prepared in (1) above for 1 minute to perform etching.

(3) Observation and Evaluation of Surface of Copper-Containing Metal Layer After Etching

The surface of the evaluation sample after etching was observed using a scanning electron microscope (SEM) (apparatus: "SU9000" manufactured by Hitachi High-Technologies Corporation) and evaluated according to the following

criteria:

◦: The etched surface of the copper-containing metal layer exhibited smoothness equivalent to that of the untreated surface, or only exhibition of very small precipitates was observed.

✕: Exhibition of concave or clearly observable sizes of precipitates on the etched surface of the copper-containing metal layer was observed.

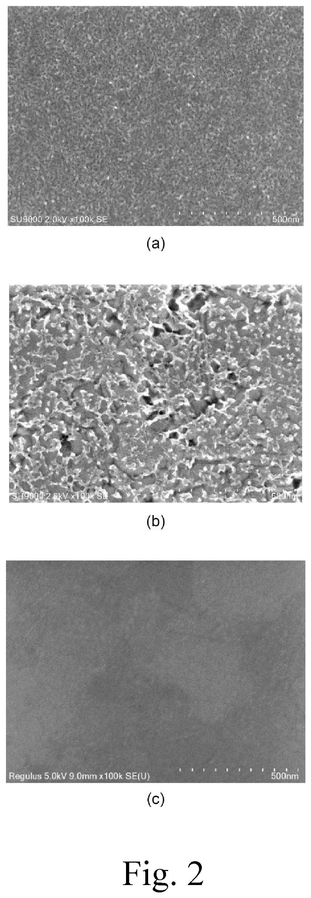

The results are shown in Table 1. As examples of the surface of the evaluation sample after etching, SEM images of the surfaces of the evaluation samples after etching in Example 1 and Comparative Example 2 and the evaluation sample that is untreated (observed at a magnification of 100,000 times) are shown in Figures 2(a), 2(b), and 2(c), respectively.

Further, according to the above-described method, the normalized spectral entropy of the surface of the copper-containing metal layer after etching was calculated based on the aforementioned scanning electron microscope (SEM) image. The results are shown in Table 1.

(4) Etching Rate of Copper-Containing Metal Layer (Cu E.R.)

Regarding the etching rate of the copper-containing metal layer, the value obtained by dividing the difference in the copper layer thickness before and after etching by the process time was defined as the etching rate and calculated. The etching rate of the etching liquid before dissolving copper ("Cu 0 ppm") and the etching rate of the etching liquid after dissolving copper ("Cu 50 ppm") are shown in Table 1.

Comparative Examples 1 to 5

An etching liquid was prepared in a manner similar to that in the Examples, except that the composition ratio (based on mass) was as shown in Table 1, and using an evaluation sample, etching was performed on a copper-containing metal layer. The etching rate of the copper-containing metal layer was calculated in the same manner as in the Examples, and the surface after etching was observed and evaluated.

The results are shown in Table 1.

[Table 1]

Table 1

| | | (A) Hydrogen peroxide | (B) Malic acid | (C) 5-amino-1H-tetrazole | (D) Water | Etching rate nm/min | | | Normalized spectral entropy | Evaluation E.R./Surface state |
|---|---|---|---|---|---|---|---|---|---|---|
| | | | | | | Cu 0 ppm | Cu 50 ppm | Δ | | |
| | Example 1 | 0.50% | 10% | 0.030% | Remainder | 26.3 | 26.3 | 0.0 | 0.902 | ○ / ○ |
| | Example 2 | 0.50% | 20% | 0.300% | Remainder | 10.6 | 12.1 | 1.5 | 0.914 | ○ / ○ |
| | Example 3 | 0.50% | 3.0% | 0.300% | Remainder | 1.9 | 0.3 | -1.6 | 0.945 | ○ / ○ |
| | Example 4 | 0.20% | 3.0% | 0.010% | Remainder | 13.5 | 13.2 | -0.3 | 0.915 | ○ / ○ |
| | Comparative Example 1 | 0.50% | 1.0% | 0.050% | Remainder | 18.6 | 13.9 | -4.8 | 0.933 | × / ○ |
| | Comparative Example 2 | 0.50% | 10% | 0.005% | Remainder | 32.0 | 37.2 | 5.2 | 0.724 | × / × |
| | Comparative Example 3 | 0.50% | 20% | 0.005% | Remainder | 27.9 | 28.4 | 0.4 | 0.768 | ○ / × |
| | Comparative Example 4 | 0.50% | 3.0% | 0.005% | Remainder | 43.1 | 39.6 | -3.5 | 0.935 | × / O |
| | Comparative Example 5 | 0.10% | 0.5% | 0.005% | Remainder | 8.0 | 5.6 | -2.4 | 0.867 | × / O |

As shown in Table 1, by treating the copper-containing metal layer with the etching liquid of the present invention, a smooth etched surface can be obtained while controlling the etching rate (Examples 1 to 4). Further, it was demonstrated that the etching liquid of the present invention can suppress the change of the etching rate even after copper is dissolved.

Meanwhile, when using the etching liquids of Comparative Examples, a favorable etched surface was not successfully obtained, and the etching rate changed after copper was dissolved.

As shown by the above-described results, the etching liquid of the present invention provides an etching rate within an appropriate range and is excellent in obtaining a smooth etched surface while controlling the amount of etching in the treatment of the copper-containing metal layer. The etching liquid of the present invention can be particularly preferably used in applications, in which it is required to control the amount of etching and the smoothness of the etched surface is important, such as recess etching. Further, it was shown that the etching liquid of the present invention does not cause the change of the etching rate even after copper is dissolved, and that the performance of the etching liquid is maintained even after copper is dissolved into the etching liquid due to using a plurality of times or for a long period of time.

REFERENCE SIGNS LIST

| | |
|---|---|
| 10 | substrate |
| 20 | interlayer insulating film |
| 30 | copper-containing metal layer |
| 40 | barrier metal layer |
| 50 | etching liquid |
| 60 | amount of recess etching |
| 100 | semiconductor substrate |

**Claims**

1.  An etching liquid for etching the surface of a copper-containing metal layer, the etching liquid comprising, based on the total amount of the etching liquid,

    (A) more than 0.1 but not more than 0.5% by mass of hydrogen peroxide,
    (B) 0.01 to 20% by mass of an organic acid that has a lowest acid dissociation constant pKa of at least 2.0,
    (C) 0.010 to 0.3% by mass of a nitrogen-containing heteromonocyclic compound, and
    (D) water,

    the inorganic acid content being less than 0.1% by mass.

2.  The etching liquid according to claim 1, wherein the component (B) is a carboxylic acid having less than three carboxyl groups.

3.  The etching liquid according to claim 1, wherein the component (B) is a carboxylic acid having less than two hydroxyl groups and at least one carbon atom that is not included in a carboxyl group.

4.  The etching liquid according to claim 1, wherein the component (B) is at least one selected from the group consisting of malic acid, succinic acid, lactic acid, and acetic acid.

5.  The etching liquid according to claim 1, wherein the component (C) is at least one selected from the group consisting of triazoles, tetrazoles, thiazoles, pyrazoles, imidazoles, and nucleic acid bases.

6.  The etching liquid according to claim 5, wherein the component (C) is at least one selected from tetrazoles having a substituent at 5-position.

7.  The etching liquid according to claim 6, wherein the component (C) is 5-amino-1H-tetrazole.

8.  The etching liquid according to claim 1, which has a pH value of lower than 4.0.

9.  The etching liquid according to claim 1, wherein the etching rate of copper is 1.5 to 40 nm/min.

10. The etching liquid according to claim 1, wherein the etching rate of copper when using the etching liquid after dissolving 50 mass ppm of copper is in the range of: the etching rate of copper when using the etching liquid before dissolving copper $\pm$ 2 nm/min.

11. The etching liquid according to claim 1, which is for performing recess etching on the surface of a copper-containing metal layer that is embedded in a via or trench formed in a semiconductor substrate.

12. A method for producing a semiconductor device, the method comprising a step of contacting the etching liquid according to any one of claims 1 to 11 with the surface of a copper-containing metal layer to perform etching.

13. The method for producing a semiconductor device according to claim 12, wherein the step comprises contacting the etching liquid with the surface of a copper-containing metal layer that is embedded in a via or trench formed in a semiconductor substrate to perform recess etching.

14. The method for producing a semiconductor device according to claim 12, wherein the normalized spectral entropy $H_n$, which is calculated from a 512-pixel x 512-pixel image data that is obtained by observing an arbitrary 500 nm x 500 nm area of the etched surface of the copper-containing metal layer obtained in the step using a scanning electron microscope, is 0.83 or more.

(a)

(b)

(c)

# Fig. 1

(a)

(b)

(c)

Fig. 2

## INTERNATIONAL SEARCH REPORT

| International application No. |
|---|
| **PCT/JP2024/026313** |

**A. CLASSIFICATION OF SUBJECT MATTER**

*H01L 21/306*(2006.01)i; *C23F 1/18*(2006.01)i
FI: H01L21/306 F; C23F1/18

According to International Patent Classification (IPC) or to both national classification and IPC

**B. FIELDS SEARCHED**

Minimum documentation searched (classification system followed by classification symbols)

H01L21/306; C23F1/18

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2017-048256 A (HITACHI CHEMICAL COMPANY, LTD.) 09 March 2017 (2017-03-09) paragraphs [0044]-[0102], [0116]-[0161], fig. 2 | 1-3, 5-14 |
| A | | 4 |
| A | WO 2021/220476 A1 (PANASONIC INTELLECTUAL PROPERTY MANAGEMENT CO., LTD.) 04 November 2021 (2021-11-04) | 1-14 |
| A | JP 2016-98386 A (KANTO KAGAKU) 30 May 2016 (2016-05-30) | 1-14 |
| A | WO 2011/099624 A1 (MITSUBISHI GAS CHEMICAL COMPANY, INC.) 18 August 2011 (2011-08-18) | 1-14 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 August 2024** | **03 September 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
Information on patent family members

International application No.

**PCT/JP2024/026313**

| Patent document cited in search report | | | Publication date (day/month/year) | Patent family member(s) | | | Publication date (day/month/year) |
|---|---|---|---|---|---|---|---|
| JP | 2017-048256 | A | 09 March 2017 | TW | 201531540 | A | |
| WO | 2021/220476 | A1 | 04 November 2021 | CN | 112739852 | A | |
| JP | 2016-98386 | A | 30 May 2016 | US | 2018/0298500 | A1 | |
| | | | | WO | 2016/080383 | A1 | |
| | | | | KR | 10-2017-0083531 | A | |
| | | | | CN | 107075693 | A | |
| WO | 2011/099624 | A1 | 18 August 2011 | US | 2012/0319033 | A1 | |
| | | | | EP | 2537960 | A1 | |
| | | | | CN | 102762770 | A | |
| | | | | KR | 10-2012-0130097 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011099624 A
- JP 2005133147 A
- JP 2009299096 A